# EUROPEAN PATENT APPLICATION

(11) **EP 4 273 920 A1**
(43) Date of publication of application: **08.11.2023**
(21) Application number: 23165441.9
(22) Date of filing: 30.03.2023
(51) Int. Cl.: H01L 23/13, H01L 23/544

(54) **ELECTRONIC COMPONENT WITH ALIGNED DIE**

(30) Priority: 04.05.2022 FI 20225383
(71) Applicant: Murata Manufacturing Co., Ltd., Nagaokakyo-shi, Kyoto 617-8555 (JP)
(72) Inventor: NURMI, Sami, 04320 Tuusula (FI); SYRJÄNEN, Teppo, 00400 Helsinki (FI)
(74) Representative: Boco IP Oy Ab

(57) **Abstract**

The disclosure relates to an electronic component comprising a first die (21), a support with a die-attachment surface (22) and a die-aligning element (241) which is adjacent to the die-attachment surface (22). The die-aligning element (241) comprises a first die-alignment wall, and a first side of the first die (21) is horizontally fixed to the first die-alignment wall with a die-attach material (23). The side of the first die (21) which is opposite to the first side of the first die (21) is horizontally unfixed.

## Description

### FIELD OF THE DISCLOSURE

The present disclosure relates to electronic components, and particularly to electronic components where a die is protected by a surrounding package. The present disclosure further concerns the alignment of the die with other parts of the component.

### BACKGROUND OF THE DISCLOSURE

Electronic dies, which may also be called chips, can be prepared by manufacturing electronic structures on a substrate and cutting the substrate into small pieces. The substrate may be a semiconductor substrate, for example a silicon substrate. Each die which is cut from the substrate may be placed inside a protective package by attaching it to a support structure and then building the package around it. The die can also be electrically connected to other chips inside the same package and/or to leads which extend to the outside of the package. The package and its contents can thereby form an electronic component which can be mounted on a circuit board.

Some dies are orientation-sensitive and have to be carefully aligned inside the package to ensure that the output of the electronic component is accurate. Orientation-sensitive dies include magnetometer dies and dies which measure inertial variables such as acceleration or angular velocity.

It is often convenient to attach the die to a die-attachment surface with a die-attach material and then build the rest of the package around the die-attachment surface. Any substantially flat surface can be used as a die-attachment surface. However, a frequent problem is that, due to the viscosity of the die-attach material, the die may rotate with respect to the die-attachment surface after it has been placed (or when it is placed) on the die-attach material. Even a small amount of flow can misalign the die before the die-attach material solidifies.

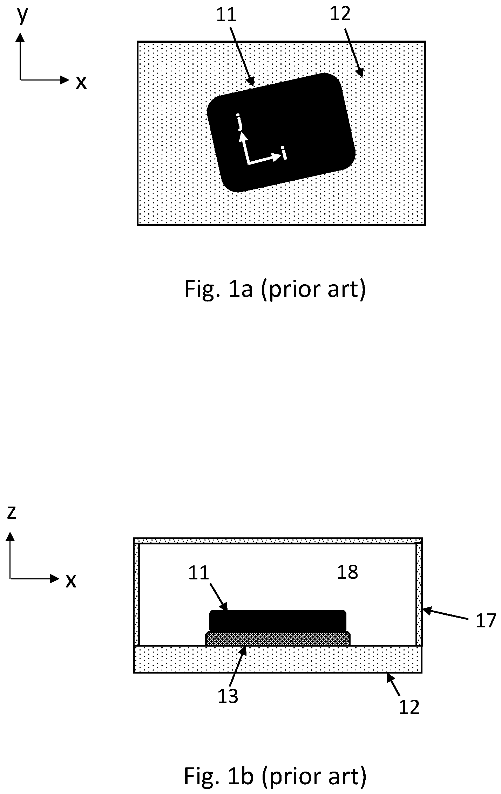

Figure 1a shown an example of a misaligned die 11 on a die-attachment surface 12 which defines an xy-plane. The same die is illustrated in figure 1b with the die-attach material 13 which attaches the die 11 to the die-attachment surface 12. The die is surrounded by a package 17 which encloses the die 11 in a protected enclosure 18. By way of example, we may assume that the die 11 comprises an acceleration-sensitive electronic structure which is designed for measuring acceleration in two perpendicular directions which correspond to the perpendicular edges of the die, illustrated with an i-axis and a j-axis on the die. We also assume that the die would be properly aligned on the die-attachment surface if the i-axis would be parallel with the x-axis and the j-axis would be parallel with the y-axis. The output of the component would then be accurate. But when the die is misaligned as figure 1a illustrates and the axes are not parallel, the measurement will be inaccurate because acceleration in the x-direction will produce an output signal both in the i-axis measurement and in the j-axis measurement. This cross-axis error can be significant even if the misalignment is small.

Document US2009166826 discloses an electronic component where a high wall surrounds an attachment area where a die is attached. A common problem with solutions where the die is fixed on all sides is that thermal expansion and other changes in the structures which surround the chip can subject the chip to mechanical stress and reduce the durability and/or the performance of the component.

### BRIEF DESCRIPTION OF THE DISCLOSURE

An object of the present disclosure is to alleviate the above problem with a method and an arrangement which are characterized by what is stated in the independent claims. Optional embodiments are presented in the dependent claims.

The disclosure is based on the idea of aligning a die to a single die-alignment wall or to two die-alignment walls. An advantage of this arrangement is that the die can be perfectly aligned without fixing it on opposite sides. The risk of damage due to mechanical stress is thereby reduced.

### BRIEF DESCRIPTION OF THE DRAWINGS

In the following the disclosure will be described in greater detail by means of preferred embodiments with reference to the accompanying drawings, in which
Figures 1a and 1b illustrate a misaligned die.
Figures 2a - 2b illustrate a die-attachment surface and die-aligning elements.
Figures 2c - 2i illustrate a die attached to a die-aligning element with a single die-alignment wall.
Figures 3a - 3b illustrate a die attached to an L-shaped die-aligning element with two die-alignment walls.
Figures 4a - 4c illustrate two dies attached to a two-sided die-aligning element with two die-alignment walls.
Figure 4d illustrates two dies attached to a two-sided die-aligning element with three die-alignment walls.

### DETAILED DESCRIPTION OF THE DISCLOSURE

This disclosure describes an electronic component comprising a first die and a support, wherein. The support comprises a die-attachment surface which defines a horizontal plane. A vertical direction is perpendicular to the horizontal plane. The first die is vertically fixed to the die-attachment surface with a die-attach material. The component also comprises a die-aligning element which is adjacent to the die-attachment surface. The die-aligning element forms an integral part of the support or an integral part of a packaging structure which is rigidly attached to the support. The die-aligning element comprises a first die-alignment wall. A first side of the first die is horizontally fixed to the first die-alignment wall with the die-attach material. The side of the first die which is opposite to the first side of the first die is horizontally unfixed.

As explained in more detail below, the die-aligning element can either be formed in the support or on a fixed structure which is adjacent to the support. The die-aligning element may be a protrusion which extends in the vertical direction from the die-attachment surface. Alternatively, it may be a protrusion which extends in a horizontal or a vertical direction from the fixed structure which is attached to the support.

The horizontal plane is illustrated as the xy-plane in this disclosure. The vertical direction is indicated with a z-axis. The term "horizontal" refers in this disclosure to directions which are parallel to the xy-plane. Terms such as "vertical", "top", "bottom", "up", "down", "below" and "above" refer in this disclosure to the direction which is perpendicular to the xy-plane and to relative positions and distances in that direction. These terms do not indicate anything about how the component should be oriented with regard to the Earth's gravitational field when the component is manufactured or when it is being used.

The "side" of a die is an external surface of the die which is vertical or at least approximately vertical when the die is placed on the die-attachment surface. A side which is opposite to another side lies on the other side of the die in a horizontal direction. The die also has a top surface and a bottom surface which are substantially horizontal when the die is placed on the die-attachment surface, and which are opposite to each other in the vertical direction.

The term "vertically fixed" refers in this disclosure to a situation where a bottom surface of a die is firmly attached with the die-attach material to the underlying die-attachment surface in the vertical direction (the z-direction). The term "horizontally fixed", on the other hand, refers to a situation where a side of the die is firmly attached with the die-attach material to a die-aligning element which is adjacent to the die in the horizontal direction (a direction parallel to the xy-plane). The term "horizontally unfixed", on the other hand, refers to a situation where a side of the die is not firmly attached to any fixed structure in a given the horizontal direction. The term "horizontally unfixed" may also be expressed as "not horizontally fixed".

The word "length" is used in this disclosure as a general term for a distance measure in the horizontal plane. Lengths can for example be measured in the direction of the x-axis, or in the direction of the y-axis, or in any other direction in the xy-plane. The alignment walls and the sides of the die are illustrated as straight walls / sides in the figures of this disclosure, and the corresponding lengths are then linear measures.

The die-alignment walls illustrated in the figures of this disclosure are straight - that is, they have a linear shape in the xy-plane. The sides of the die are correspondingly illustrated with a linear shape. However, if the side of the die is curved, then the die-alignment wall can also be curved. The length of the wall and the length of the side may in this case be measured along the curve.

In any embodiment presented in this disclosure, the first die may for example be an accelerometer configured to measure acceleration, a gyroscope configured to measure angular rotation, or a magnetometer, or any other orientation-sensitive die. The accelerometer or gyroscope may be a MEMS accelerometer / gyroscope.

The electronic component may comprise a package which provides protection for the dies inside the component. The electronic component may alternatively be without a package. The electronic component may comprise external contacts and mounting elements which allow the component to be attached and electrically connected to a circuit board. The component may be mounted on a circuit board so that the circuit board is closer to the die-attachment surface than to the die, or it may be mounted the other way around so that the circuit board is closer to the die than to the die-attachment surface.

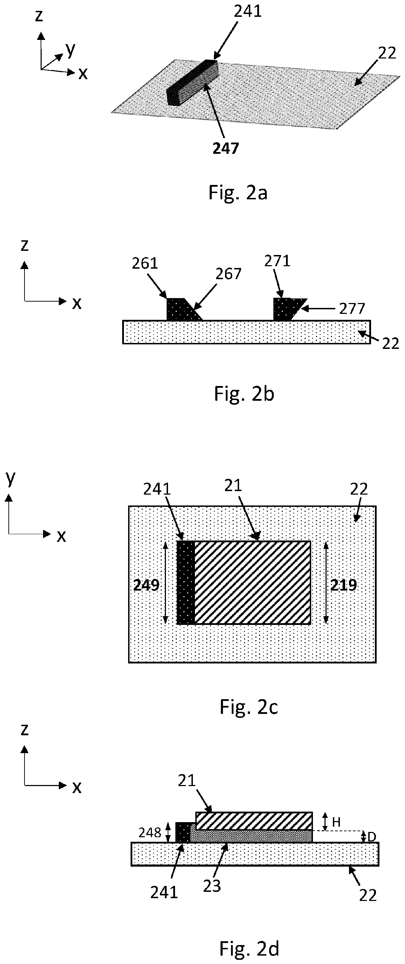

To facilitate a simple illustration of die alignment in the figures of this disclosure, both the die itself and the die-attachment surface are illustrated as rectangular blocks with straight edges extending parallel to the x-axis and the y-axis. The die is then assumed to be oriented correctly when the four edges of the rectangular die are parallel to the four edges of the die-attachment surface, as figure 2b for example illustrates. However, the die and the die-attachment surface could in reality have more complicated shapes than the figures of this disclosure illustrate. The die may for example have the shape of a polygon with straight edges which form the sides of the die.

The general principles of alignment are the same regardless of the shape of the die. When the directional alignment of the die is correct, the relevant measurement axes on the die (such as axes i and j in figure 1a) are oriented correctly with respect to a given direction (for example the x-direction) on the horizontal die-alignment surface. When the positional alignment of the die is correct, the location of every part of the die with respect to a given point on the die-alignment surface is correct. As described in more detail below, the alignment arrangements described in this disclosure are primarily focused on directional alignment. When the directional alignment of the orientation-sensitive dies inside an electric component is correct, the output of the electronic component will accurately reflect the orientation of the component. Positional alignment is also important in some applications, and it can also be achieved in some embodiments described in this disclosure.

Figure 2a illustrates a die-attachment surface 22 and a die-aligning element 241 on the die-attachment surface. The die-aligning element could be a part which is initially separate from the die-attachment surface and then attached to a desired place on the die-attachment surface with the correct orientation. However, the die-alignment problems which were discussed above would apply equally to the orientation of the die-aligning element if it is attached to the die-attachment surface for example with an adhesive. It is therefore preferable to form the die-aligning element 241 as an integral part of the support. Both the die-aligning element 241 and the die-attachment surface 22 may then be formed by shaping the support so that they are next to each other. The orientation of the die-aligning element with respect to the support, and with respect to the edges of the die-attachment surface in the xy-plane, can then be secured with high accuracy.

The die-aligning element 241 may be a protrusion in the die-attachment surface 22. It may be formed from the same material as the die-attachment surface 22. The die-aligning element 241 and the die-attachment surface 22 can be made of any material, and the material of the die-aligning element may be either the same as the material of the die-attachment surface, or different from the material of the die-attachment surface. Even though the die-aligning element may be an integral part of the support, the die-attachment surface 22 and the die-aligning element 241 are for reasons of clarity illustrated with a different color in the figures of this disclosure.

For simplicity, the die-aligning element is illustrated as a cuboid in figure 2a and as a rectangle in most of the two-dimensional figures. However, the die-aligning element may have any shape as long as it comprises a die-alignment wall 247. The wall may be a straight and flat surface as figure 2a illustrates, but other shapes are also possible as long as the shape of the wall corresponds to the shape of the side of the die which is intended to be attached to the die-alignment wall. Any die-alignment wall described in this disclosure may be vertical, like the die-alignment wall 247 in figure 2a which is parallel to the yzplane. However, perfect verticality is not needed. The die-alignment wall could alternatively be tilted for example at an angle between 45 and 90 degrees with respect to the die-attachment surface, with 90 degrees being a fully orthogonal orientation. Figure 2b illustrates two alternative die-aligning elements 261 and 271, with corresponding die-alignment walls 267 and 277 tilted in opposite directions. The vertical height of a die-alignment wall corresponds to the z-coordinate of the upper edge of the die-alignment wall (when the z-coordinate of the die-attachment surface is zero). The options presented in figures 2a and 2b can be combined with any other embodiment presented in this disclosure.

Also, although the die-alignment walls illustrated in the figures of this disclosure are parallel to the illustrated edges of the die-attachment surface 22, the die-alignment wall can be oriented in any direction on the surface. It is only important that the orientation of the die-alignment allows the die to be oriented correctly when it attaches to the die-alignment wall.

Figures 2c and 2d illustrate a first die 21 on the die-attachment surface 22. The first die has a first side (the left side in figures 2c and 2d) which is intended to be attached to the die-aligning element 241. The die 21 is placed on top of a layer of die-attach material 23 close to the die-aligning element 241 on the die-attachment surface 22. In any embodiment of this disclosure, the die-attach material may be an adhesive or paste, for example an epoxy- or silicon-based adhesive or paste. The die-attach material may be a dispensable liquid when it is applied to the die-attachment surface. The die-attach material 23 has some degree of viscosity when the die 21 is placed on top of it. The die therefore "floats" on die-attach material. As the material gradually solidifies, the die 21 is firmly attach to the die-attachment surface and to the die-alignment wall.

Figure 2d illustrates the alignment mechanism which is used in all embodiments of this disclosure. When the die 21 on the die-attach material 23 is placed sufficiently close to the die-aligning element 241 and its die-alignment wall, so that the die-attach material makes contact with the die-alignment wall, capillary forces and surface-tension forces will pull the viscous die-attach material in between the die 21 and the die-aligning element 241 as shown in figure 2d. As the die-attach material solidifies, the side of the die (here the left side) will become attached to the die-alignment wall.

If the side of the die 21 is close to being parallel to the die-alignment wall when the die is placed near the die-aligning element, but not perfectly parallel - that is, if the die is slightly misaligned - then the capillary and surface-tension forces which act on the viscous die-attach material 23 will strive to automatically correct this error by equalizing the thickness (both in the x-direction and the z-direction) of the die-attach material interface layer which is formed between the wall and the side of the die. The die-attach material 23 will thereby rotate the die 21 slightly and bring the side of the die into perfect alignment with the die-alignment wall. This effect can be obtained as long as the initial misalignment is not too large and the distance between the die and the die-aligning element when the die is placed on the die-attachment surface is sufficiently small. The maximum amount of initial misalignment which can still be corrected will depend at least on the size of the die 21, the viscosity of the die-attach material 23 and the height of the die-aligning element 241.

The horizontal bond line between the die-attach material 23 and the die 21 is illustrated in figure 2d. The vertical height of this bond line - that is, the distance from the die-attachment surface 22 to the bond line - is labelled D. The vertical height of the die 21 - the distance from its bottom surface to its top surface - is labelled H. If the die does not have uniform thickness, the vertical height of the die may be interpreted as the vertical height of the side of the die which is intended to be attached to the die-aligning element.

The vertical height 248 of the die-alignment wall has been marked in figure 2d. This height should be greater than D to facilitate the alignment mechanism which was explained above. Furthermore, in some cases the height 248 may be less than D + H/2. In other words, the die-alignment wall may in some cases not extend above the vertical midplane of the die 21 (or the vertical midpoint of the side of the die which is intended to be attached to the die-aligning element). Alternatively, the first wall height 248 could be in the range between D and D + H/3, or in the range between D and D + H/4, or in the range between D and D + H/5. These relatively low wall heights will align the die without fixing it horizontally to a large surface area. Horizontal fixing across a large area may subject the die to one-sided, asymmetric mechanical stress which may damage some dies or affect their performance. However, dies which are not so sensitive can be horizontally fixed also on larger surface areas. When such dies are aligned the first wall height may be greater than D+H/2. These height options apply also to the second and third wall heights which will be introduced below.

In other words, the vertical distance from the die-attachment surface to the bond line between the first die and the die-attach material may be D, and the vertical height of the first die may be H, and the first die-alignment wall may have a first wall height in the vertical direction, and the first wall height may be greater than D and less than D + H/2.

A die has multiple sides. Some of these sides are opposite to each other, as for example the left and right sides of the die in figure 2c and 2d. When one side of the die is fixed, the opposite side of the die should be left unfixed - in figures 2c and 2d the left side is horizontally fixed while the right side is not horizontally fixed. Fixing the die horizontally to a rigid structure on two opposing sides of the die would carry the risk of subjecting the die to strong mechanical stresses. The alignment process described above may also not function optimally if they take place simultaneously on two opposing sides, and the directional and positional alignment may consequently degrade.

The length 249 of the die-alignment wall is illustrated in figure 2c. The length is illustrated in the y-direction in figure 2c, but more generally the length of the die-alignment wall is measured along the non-vertical dimension of the wall. The length 219 of the first side of the die 21 is also illustrated in figure 2c. Since 241 and 21 are illustrated with a rectangular shape, the length 249 are indicated on the left side of the die-aligning element 241 and the length 219 on the right side of the die 21. In practice, both of these lengths 249 and 219 should be measured at the interface between the die-aligning element 241 and the die 21.

The length 249 of the first die-alignment wall may be substantially equal to the length 219 of the first side of the first die 21. When this is the case, the forces which act on the viscous die-attach material will not only produce directional alignment of the die, but also positional alignment. That is, if in the initial position one end of the first side of the die 21 would extend past the die-alignment wall in the y-direction, and the die-alignment wall would extend past the other end of the first side of the die 21 in the opposite y-direction, then the die-attach material would act to bring the die 21 into the perfect positional alignment illustrated in 2c, where the ends of the first side of the die 21 and the die-alignment wall coincide.

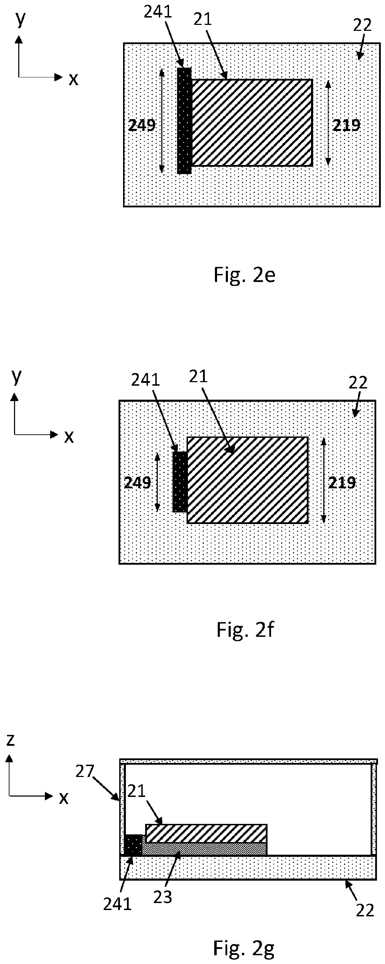

However, the length 249 of the first die-alignment wall does not necessarily have to be equal to the length of the first side of the first die. Longer or shorter walls can be used in applications where positional alignment is not critical. Figure 2e illustrates a device where the length 249 is greater than the length 219. In this case the directional alignment of the die 21 will be correct, but the positional alignment of the die 21 will depend on how accurately it is placed on the die-attachment surface 22 - the forces which act on the die-attach material will not produce additional improvements in positional alignment. The same holds for figure 2e, where the length 219 is greater than the length 249. The options presented in figures 2e and 2f can be combined with any other embodiment presented in this disclosure.

The die-aligning element may, but does not necessarily have to be, in contact with the sidewall of a package which surrounds the die. Figure 2g illustrates a device where the die-aligning element 241 has been placed on the die-attachment surface between the sidewall of the package 27 and the die 21.

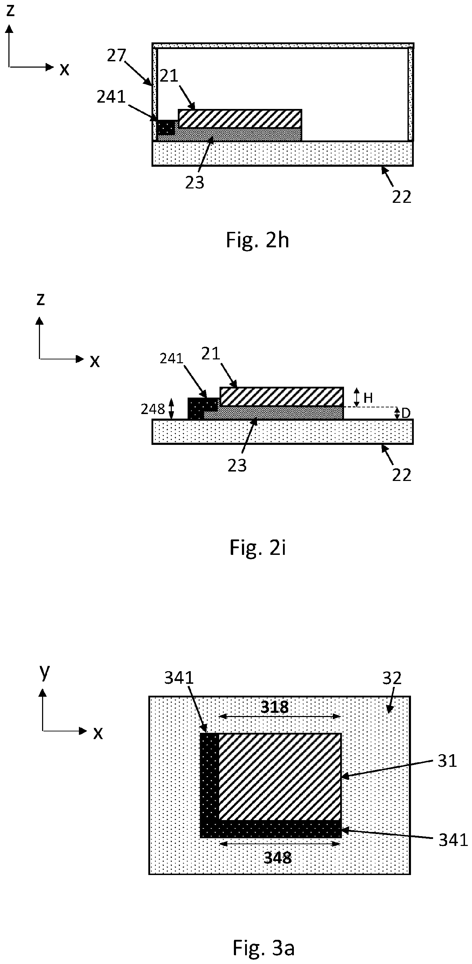

Furthermore, the die-alignment wall does not necessarily have to extend all the way down to the die-attachment surface. Figure 2h illustrates an electronic component where the die-aligning element 241 protrudes outward from the sidewall of the package structure 27 without extending all the way down to the die-attachment surface 22. The die-aligning element 241 may be an integral part of the sidewall. It may be an integral part of the package. The die-aligning element 241 may be a protrusion in the sidewall. The die-aligning element 241 has a die-alignment wall on its right side in figure 2h, and the die 21 can be aligned to this wall with the mechanism which was described above.

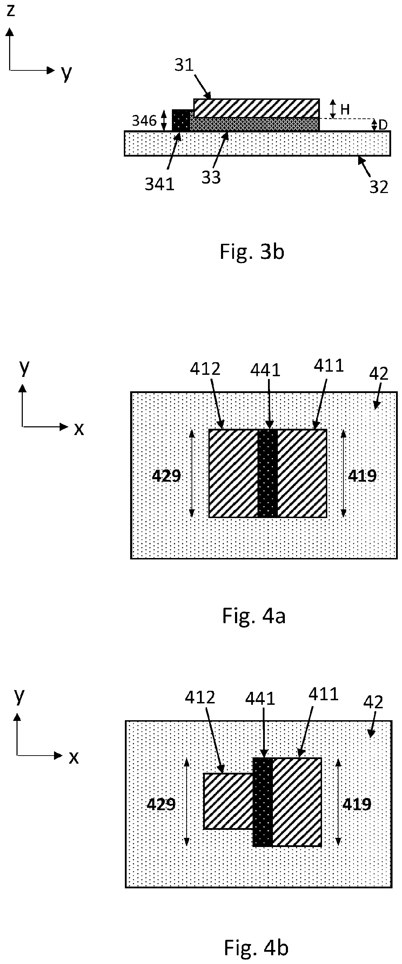

The package structure 27 is fixed to the support, and to the die-attachment surface 22. The package structure may for example be a cap which forms an enclosure around the chip. The die-aligning element could alternatively be a protrusion which extends downward in the vertical from the ceiling of the package structure. This option has not been illustrated. All geometry options discussed above with reference to figures 2a - 2g, and below with reference 3a - 4d, apply both to die-aligning elements which are formed as integral parts of the support and to die-aligning elements which are formed as integral parts of the packaging structure. In particular, even though the chip is illustrated as being horizontally fixed in the x-direction in figure 2h, it would alternatively be possible to form the die-aligning element into an elongated structure which protrudes so far out from the sidewall 27 that chips can be aligned to it in the y-direction (possible from two different directions, as in figure 4a).

To facilitate accurate directional alignment in the embodiment shown in figure 2h, the package sidewall must be aligned precisely in the right direction. Figure 2i illustrates an alternative embodiment where the orientation of the die-aligning element 241 is not dependent on the package sidewall, but the die-alignment wall still does not extend all the way down to the die-attachment surface. The die-aligning element here rests on the die-attachment surface 22, but the die-alignment wall (the right side of the die-aligning element which facilitates die alignment) nevertheless does not extend down to the die-attachment surface 22. As explained above, the vertical height of a die-alignment wall is the z-coordinate of the upper edge of the die-alignment wall (when the z-coordinate of the die-attachment surface is zero), regardless of whether or not the walls extends all the way down to the die-attachment surface or not. In both figures 2h and 2i, the lower edge of the die-alignment wall may lie above or below the bond line which is illustrated with a dashed line in figure 2i. The options presented in figures 2h and 2i can be combined with any other embodiment presented in this disclosure.

The directional and positional alignment of the die can in some applications be improved by using two die-alignment walls which are not parallel to each other. Two different sides of the die can then be attached to these two walls.

The die-aligning element may also comprise a second die-alignment wall which is not parallel to the first die-alignment wall. A second side of the first die may be horizontally fixed to the second die-alignment wall with the die-attach material. The second side of the first die is not opposite to the first side of the first die. The side of the first die which is opposite to the second side of the first die is horizontally unfixed.

Figures 3a - 3b illustrate a die-aligning element 341 which is shaped like the letter L. Reference numbers 31, 32, 33 and 341 correspond to reference numbers 21, 22, 23 and 241, respectively in figures 2a - 2i. The left side of the die-aligning element 341 forms the same kind of first die-alignment wall which has already been discussed at length above. The side of the die-aligning element 341 which extends parallel to the x-axis in figure 3a forms a second die-alignment wall (the wall which faces towards the die 31 in the y-direction). As figure 3a illustrates, the length 348 of the second die-alignment wall is substantially equal to the length 318 of the second side of the first die 31. The second side of the die may be adjacent to the first side of the die, meaning that these sides are next to each other (no third side lies between them). It may alternatively be an adjacent side which is not a direct neighbour if the die has lots of sides.

The flow of the die-attach material into the space between the die and the die-alignment wall and the tendency of the die-attach material to minimize its surface tensions will act to align the die 31 with the second die-alignment wall, just as it aligns the die with the first die-alignment wall. This is illustrated in figure 3b, which corresponds figure 2d except for the fact that the illustrated cross-section is a yz-cross-section. The second wall height is indicated as 346.

The length of the second die-alignment wall may be substantially equal to the length of the second side of the first die. However, as in the case of the length of the first die-alignment wall which was discussed above with reference to figures 2c - 2f, the second die-alignment wall may alternatively be shorter or longer than the length of the second side of the first die. The second die-alignment wall has a second wall height in the vertical direction, and the second wall height may for example greater than D and less than D + H/2. Any of the other height options presented above for the first wall height may also apply to the second wall height.

The first wall height may be substantially equal to the second wall height. However, this does not necessarily have to be the case. The alignment can be just as accurate if one of the walls is higher than the other, and it may in some cases be advantageous to make one of the walls higher so that it can serve as a primary die-alignment wall while the other is lower so that the risk of mechanical stress on the die is reduced.

The first and second die-alignment walls are orthogonal in figure 3a, but the angle between these two walls can alternatively have some other value. It simply has to be equal to the angle between the first and second sides of the die which are to be attached to the walls. If, for example, the die would have the shape of a pentagon, then the angle between the first and the second die-alignment walls should be 108 degrees (equal to the angle between two sides of a pentagon).

The die-aligning element 341 illustrated in figure 3a could be separated into two different die-aligning elements, each with its own die-alignment wall. A die could in some cases also be aligned to one or more die-aligning elements by attaching two sides of the die which are not next to each other (especially if the die has five or more sides).

The options and alternatives that have been explained above with reference to figures 3a and 3b can be combined with any other embodiment presented in this disclosure.

A die-aligning element may be used to align multiple dies. The component may comprise a second die which is attached to the die-attachment surface with an additional die-attach material. The die-aligning element may comprise an additional die-alignment wall. A first side of the second die may be horizontally fixed to the additional die-alignment wall with the additional die-attach material. The side of the second die which is opposite to the first side of the second die may be horizontally unfixed.

Figure 4a illustrates a two-sided die-aligning element 441 which comprises an additional die-alignment wall (which may be called the second or the third die-alignment wall). Reference numbers 411, 419, 42 and 441 correspond to reference numbers 21, 219, 22 and 241, respectively, in figures 2a - 2i. The first die 411 is attached to the first die-alignment wall (the right side of the die-aligning element 441 in figure 4a) and a second die 412 is attached to the additional die-alignment wall (the left side of the die-aligning element 441 in figure 4a).

The second die 412 has a first side (the right side in figure 4a) which is intended to be attached to the die-aligning element 441. The die 41 is placed on top of a layer of die-attach material (not illustrated) on the left side of the die-aligning element 441 on the die-attachment surface 42. If the second die 412 is close enough to the additional die-alignment wall, the second die 412 will then be attached and aligned to the additional die-alignment wall by the mechanism which was described above. The placement of the die-aligning element, the additional die-attach material and the die itself may correspond to figure 2d.

The additional die-alignment wall may be parallel to the first die-alignment wall as figure 4a illustrates. However, the additional die-alignment wall could alternatively be oriented in any other direction. The orientation will depend on the desired alignment direction of the second die 412.

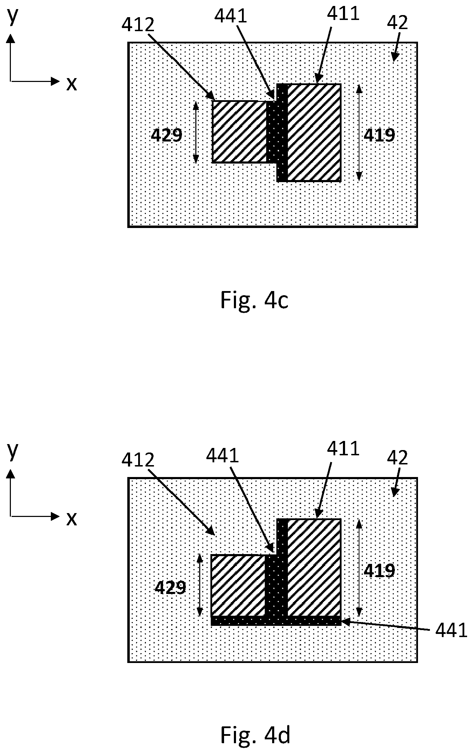

The length 429 of the additional die-alignment wall may be equal to the length of the first side of the second die. However, the length of the first side of the second die may alternatively be shorter, as figure 4b illustrates, or longer (this option has not been illustrated). Furthermore, the length 419 of the first die-alignment wall may be equal to the length 429 of the additional die-alignment wall, as figure 4b illustrates. Alternatively, 429 could be shorter than 419, as figure 4c illustrates, or vice versa.

The vertical distance from the die-attachment surface to the bond line between the second die and the additional die-attach material may be D*. The vertical height of the second die may be H*. The additional die-alignment wall may have a third wall height in the vertical direction, and the third wall height may be greater than D* and less than D* + H*/2.

Finally, the die-aligning element which comprises a first die-alignment wall and an additional die-alignment wall may also comprise the second die-alignment wall which was discussed above with reference to figures 3a and 3b. All options described above with reference to these figures apply also when the additional die-alignment wall is included. Either the first die, the second die, or both the first and the second die may be attached to the second die-alignment wall. Figure 4d illustrates a component where both the first and the second die are attached.

### Methods

This disclosure also describes a method for manufacturing an electronic component comprising one or more dies attached to a support. The support comprises a die-attachment surface which defines a horizontal plane. A vertical axis is perpendicular to the horizontal plane. The method comprises the step of fixing a first die vertically to the die-attachment surface with a die-attach material. The method also comprises the step of forming a die-aligning element as an integral part of the support or as an integral part of a packaging structure which is rigidly attached to the support. The die-aligning element is adjacent to the die-attachment surface. The die-aligning element comprises a first die-alignment wall., The method also comprises the step of fixing a first side of the first die horizontally to the first die-alignment wall with the die-attach material while leaving the side of the first die which is opposite to the first side of the first die horizontally unfixed.

The step of attaching a first side of the first die to the first die-alignment wall with the die-attach material may comprise the following substeps: (A) placing the die-attach material on the support close to the die-aligning element, and (B) placing the first die onto the die-attach material so that the first side of the first die is in close proximity to the first die-alignment wall.

All options presented above with reference to 2a - 2g apply also to this method.

If the first die is initially misaligned, the die can (as long as the initial misalignment is not too large) be brought into perfect alignment as the die-attach material creeps up between the die and the die-alignment wall and forms an intermediate layer between the die and the wall. The initial distance DD between the die and the die-aligning element when the die is placed on the die-attachment surface should not be too large. This distance DD may preferably the shorter than the distance DO between the die and any other adjacent fixed element on the support surface. DD may for example be less than half of DO or less than three quarters of DO. The minimum value for DD, as well as the maximum amount of initial misalignment which can be corrected, will depend at least on the size of the die, the viscosity of the die-attach material and the height of the die-aligning element.

The options presented above with reference to 3a - 3b may also be implemented in the method. In other words, the die-aligning element may comprise a second die-alignment wall which is not parallel to the first die-alignment wall, and the method may comprise the step of fixing a second side of the first die horizontally to the second die-alignment wall with the die-attach material while leaving the side of the first die which is opposite to the second side of the first die horizontally unfixed, wherein the second side of the first die is not opposite to the first side of the first die.

The step of fixing the first and second sides of the first die to the first and second die-alignment wall, respectively, may in this case comprise the following substeps: (A) placing the die-attach material on the support close to the die-aligning element, and (B) placing the first die onto the die-attach material so that the first side of the first die is in close proximity to the first die-alignment wall and the second side of the first die is in close proximity to the second die-alignment wall.

Finally, the options presented above with reference to 4a - 4d may also be implemented in the method. In other words, the first die-aligning element may also comprise an additional die-alignment wall and the method may comprise the step of fixing a second die vertically to the die-attachment surface and fixing a first side of the second die horizontally to the additional die-alignment wall with an additional die-attach material, while leaving the side of the second die which is opposite to the first side of the second die horizontally unfixed.

The step of fixing the first side of the second die to the additional die-alignment wall, may in this case comprise the following substeps: (A) placing the additional die-attach material on the support close to the die-aligning element, and (B) placing the second die onto the additional die-attach material so that the first side of the second die is in close proximity to the additional die-alignment wall.

Any of the options presented above relating to the heights of the first and second die-alignment walls, the additional die-alignment wall, the bond line and the first and second dies can be applied in these methods as well.

## Claims

1. An electronic component comprising a first die and a support, wherein
- the support comprises a die-attachment surface which defines a horizontal plane, and a vertical direction is perpendicular to the horizontal plane, and
- the first die is vertically fixed to the die-attachment surface with a die-attach material,
**characterized in that** the component also comprises a die-aligning element which is adjacent to the die-attachment surface, and the die-aligning element forms an integral part of the support or an integral part of a packaging structure which is rigidly attached to the support, wherein the die-aligning element comprises a first die-alignment wall, and a first side of the first die is horizontally fixed to the first die-alignment wall with the die-attach material, and the side of the first die which is opposite to the first side of the first die is horizontally unfixed.

2. An electronic component according to claim 1, wherein the length of the first die-alignment wall is substantially equal to the length of the first side of the first die.

3. An electronic component according to any of claims 1-2, wherein the vertical distance from the die-attachment surface to the bond line between the first die and the die-attach material is D, and the vertical height of the first die is H, and the first die-alignment wall has a first wall height in the vertical direction, and the first wall height is greater than D and less than D + H/2.

4. An electronic component according to any of claims 1-3, wherein the die-aligning element also comprises a second die-alignment wall which is not parallel to the first die-alignment wall, and a second side of the first die is horizontally fixed to the second die-alignment wall with the die-attach material, wherein the second side of the first die is not opposite to the first side of the first die, and the side of the first die which is opposite to the second side of the first die is horizontally unfixed.

5. An electronic component according to claim 4, wherein the length of the second die-alignment wall is substantially equal to the length of the second side of the first die.

6. An electronic component according to any of claims claim 4-5, wherein the second die-alignment wall has a second wall height in the vertical direction, and the second wall height is greater than D and less than D + H/2.

7. An electronic component according to claim 6, wherein the first wall height is substantially equal to the second wall height.

8. An electronic component according to any preceding claim, wherein the component also comprises a second die which is attached to the die-attachment surface with an additional die-attach material, and the die-aligning element also comprises an additional die-alignment wall, wherein a first side of the second die is horizontally fixed to the additional die-alignment wall with the additional die-attach material, and the side of the second die which is opposite to the first side of the second die is horizontally unfixed.

9. An electronic component according to claim 8, wherein the length of the additional die-alignment wall is equal to the length of the first side of the second die.

10. An electronic component according to any of claims 1-2, wherein the vertical distance from the die-attachment surface to the bond line between the second die and the additional die-attach material is D*, and the vertical height of the second die is H*, and the additional die-alignment wall has a third wall height in the vertical direction, and the third wall height is greater than D* and less than D* + H*/2.

11. A method for manufacturing an electronic component comprising one or more dies attached to a support, wherein the support comprises a die-attachment surface which defines a horizontal plane, and a vertical axis is perpendicular to the horizontal plane, and the method comprises the step of:
- fixing a first die vertically to the die-attachment surface with a die-attach material, **characterized in that** the method also comprises the steps of:
- forming a die-aligning element as an integral part of the support or as an integral part of a packaging structure which is rigidly attached to the support, wherein the die-aligning element is adjacent to the die-attachment surface and the die-aligning element comprises a first die-alignment wall, and
- fixing a first side of the first die horizontally to the first die-alignment wall with the die-attach material while leaving the side of the first die which is opposite to the first side of the first die horizontally unfixed.

12. A method according to claim 10, wherein the die-aligning element also comprises a second die-alignment wall which is not parallel to the first die-alignment wall, and the method also comprises the step of:
- fixing a second side of the first die horizontally to the second die-alignment wall with the die-attach material while leaving the side of the first die which is opposite to the second side of the first die horizontally unfixed, wherein the second side of the first die is not opposite to the first side of the first die.

13. A method according to any of claims 10-11, wherein the die-aligning element also comprises an additional die-alignment wall, and the method also comprises the steps of:
- fixing a second die vertically to the die-attachment surface and fixing a first side of the second die horizontally to the additional die-alignment wall with an additional die-attach material, while leaving the side of the second die which is opposite to the first side of the second die horizontally unfixed.
